# EUROPÄISCHE PATENTSCHRIFT

(11) **EP 1 567 300 B1**
(45) Veröffentlichungstag und Bekanntmachung des Hinweises auf die Patenterteilung: **14.06.2006**
(21) Anmeldenummer: 03780095.0
(22) Anmeldetag: 01.12.2003
(51) Int. Cl.: B23K 1/005, H05K 3/34, B23K 35/00, G02B 6/42, C04B 37/00, C03C 17/00, C03C 17/06

(54) **Verfahren zur Lötbefestigung miniaturisierter Bauteile auf einer Grundplatte, eine Grundplatte und ein Substrat**
Method for soldering miniaturised components to a base plate, a base plate and a substrate
Procédé de brasage de composants miniatures sur une plaque de base, une plaque de base et un substrat

(30) Priorität: 29.11.2002 EP 02026648
(43) Veröffentlichungstag der Anmeldung: 31.08.2005
(73) Patentinhaber: Leica Geosystems AG, 9435 Heerbrugg (CH)
(72) Erfinder: ROSSOPOULOS, Stephane, CH-1412 Ursins (CH); VERETTAS, Irène, CH-1007 Lausanne (CH); CLAVEL, Reymond, CH-1377 Oulens/Echallens (CH)
(74) Vertreter: Kaminski, Susanne
(86) Internationale Anmeldenummer: PCT/EP2003/013519
(87) Internationale Veröffentlichungsnummer: WO 2004/050287

(56) Entgegenhaltungen:
- WO-A-01/37019
- WO-A-99/26754
- GB-A- 1 051 393
- US-A- 3 590 467
- US-B1- 6 284 998
- US-B1- 6 353 202
- US-B1- 6 394 158

## Beschreibung

Die vorliegende Erfindung betrifft ein Verfahren zur hochpräzisen Befestigung miniaturisierter Bauteile auf einer Grundplatte durch eine Lötverbindung (siehe Anspruch 1), eine Grundplatte gemäß dem Oberbegriff des Anspruchs 15 und ein Substrat (Anspruch 20). Vor allem bezieht sich die Erfindung sowohl auf ein Laserlötverfahren zum Fixieren mikrooptischer Bauteile auf eine Grundplatte, die zumindest teilweise laserstrahlendurchlässig und mit einer Metallschicht beschichtet ist, als auch auf die durch das Verfahren erlangte Grundplatte und ein Substrat zur Verwendung in dem Verfahren.

Unterschiedliche Verfahren zum Befestigen miniaturisierter Bauteile mittels einer Lötverbindung sind aus dem Stand der Technik bekannt.

In der WO 99/26754, die als nächsliegender Stand der Technik für die Ansprüche 1, 15 und 20 angesehen wird, wird ein Verfahren zur Lötbefestigung miniaturisierter Bauteile auf einer Grundplatte beschrieben. Die Grundplatte wird zumindest teilweise mit einem gitterförmigen Metallmuster bzw. einer Metallstruktur beschichtet. Gemäss der WO 99/26754 kann die Musterstruktur von einem Gitter aus Flächenelementen oder einer Reihe von sich bevorzugt senkrecht schneidenden Streifen gebildet sein, die ein Gitter oder sonst irgendeine Struktur bilden, die durch einen gleichförmigen Wechsel von Metallbereichen und freien Bereichen gekennzeichnet ist. Die Flächenelemente können eine rechteckige Form, eine quadratische Form, eine runde Form oder irgendeine Form annehmen, die geeignet ist, bei diesem Verfahren verwendet zu werden. Die Musterschrittweite sollte hierbei wenigstens eine Grössenordnung kleiner sein als die Abmessungen der zu befestigenden Seite des Bauteils. Das Lötmaterial wird vorzugsweise auf der zu befestigenden Seite des Bauteils oder gegebenenfalls auf dem Metallmuster der Grundplatte aufgebracht. Das Bauteil wird oberhalb der Grundplatte angeordnet, wobei sich das Metallmuster und die Lötmaterialschicht des Bauteils bzw. die Lötmaterialschicht auf dem Metallmuster und die Seite des Bauteils in berührungsfreier, vertikal beabstandeter Gegenüberlage befinden. Dann wird Wärmeenergie von der unbeschichteten Seite der Grundplatte zum Schmelzen von Lötmaterial der Lötmaterialschicht auf der beschichteten Seite, auf der auch das Bauteil angeordnet ist, bis zu einer Tropfenbildung des Lötmaterials zugeführt, wodurch der Lötmaterialtropfen den Zwischenraum zwischen dem Bauteil und der Grundplatte zur gegenseitigen Befestigung füllt. Die metallisierten Musterbereiche liefern einen Befestigungsbereich für das Lötmaterial, während es die metallfreien Bereiche ermöglichen, dass eine ausreichende Energiemenge durch die Grundplatte hindurchgehen kann, um das Lötmaterial zu schmelzen. Beim Zuführen der Wärmeenergie geht somit ein Teil der Energie durch die unbeschichteten Bereiche des Metallmusters. Derjenige Teil, der auf die mit Metall beschichteten Bereiche des Metallmusters gelangt, erwärmt entweder die Metallschicht oder wird reflektiert. Die Energie wird vorzugsweise mittels eines Laserstrahls aufgebracht. Aufgrund der Gitterstruktur des Metallmusters auf der Grundplatte ist die Wahl eines geeigneten Lichtabsorptionskoeffizienten der Metallschicht besonders problematisch, da einerseits die Grundplatte nicht überhitzen darf, andererseits eine gewisse Mindesttemperatur zur Durchführung des Prozesses erforderlich ist. Üblicherweise werden von dem Metallmuster etwa 70% der Oberfläche der Grundplatte mit Metall abgedeckt. Weniger als 30% der Leistung des Laserstrahls wird zum Erhitzen des Lötmaterials verwendet, da der eine Teil der etwa 70% der verbleibenden Leistung die Grundplatte erwärmt und der andere Teil reflektiert wird.

Zur Durchführung eines Lötvorgangs werden über 15 W für die Dauer von 2 Sekunden benötigt. Unterschiedliche Arten von Metallbeschichtungen sind in Abhängigkeit des gewählten Materials der Grundplatte erforderlich. Ausserdem kommt es zu einem diskreten Effekt aufgrund des Metallmusters, falls das Lötmaterial lediglich die mit der Metallschicht beschichteten Bereiche des Metallmusters benetzt, nicht jedoch - insbesondere aufgrund des Fliessverhaltens und der Oberflächenspannung - die unbeschichteten metallfreien Bereiche des Metallmusters. Insbesondere bei einem im Verhältnis zur Grösse der zu befestigenden Seite des Bauteils groben Metallmuster können sich somit asymmetrische aussermittige Lötnähte ergeben, die - bedingt durch die zwangsläufig während der Erstarrung stattfindende Schrumpfung des Lötmaterials - mit einer Positionsveränderung des Bauteil und/oder einer Schräglage verbunden sind.

In der Praxis hat sich ergeben, dass das Lötmaterial nahe der Querseiten des Bauteils wesentlich schneller abkühlt als der Rest des Lötmaterials. Dies kann zu Asymmetrien des erstarrten Lötmaterials führen.

Da die Befestigung durch das Löten zweier unterschiedlicher Materialien erfolgt, verursachen unterschiedliche Wärmeausdehnungskoeffizienten beim Lötmaterial und der Grundplatte hohe Spannungen und Verzüge nach Durchführung des Lötverfahrens. Abhängig vom mechanischen Widerstand des Trägermaterials kann eine parasitäre örtliche Verformung im Bereich der Lötverbindung aufgrund der hohen Spannungen entstehen.

Durch das oben beschriebene, bekannte Verfahren sind Genauigkeiten von etwa 2 Mikron in den 6 Freiheitsgraden erzielbar. Vor allem für die Montage von Bauteilen, die mikrooptische Elemente beinhalten oder tragen, sind jedoch noch höhere Montagegenauigkeiten erforderlich.

Daher besteht das Bedürfnis, das oben beschriebene, in der WO 99/26754 offenbarte Verfahren zu verbessern, um eine höhere Montagegenauigkeit miniaturisierter Bauteile, insbesondere mikrooptischer Elemente, auf einer Trägerplatte zu erzielen und das gesamte Verfahren in wirtschaftlicher Hinsicht zu optimieren.

Weiters ist ein flussmittel- und/oder bleiloses Löten im oben beschriebenen Verfahren kaum möglich. Versuche haben ergeben, dass die Verwendung von flussmittellosem Lötmaterial aus Sn96Ag4 und einer Metallschicht, beschichtet mit Zinn, Nickel und Gold, nicht zu den erhofften zufriedenstellenden Ergebnissen führt, wenn die Befestigung auf einem Metallmuster, wie in der WO 99/26754 beschrieben, erfolgt, da ein Metallmuster eine unzureichende Benetzbarkeit aufweist.

Zahlreiche weitere Verfahren zur Befestigung kleiner Bauteile auf einer Trägerplatte sind aus dem Bereich der Bestückungstechnik elektronischer oberflächenmontierter Schaltungen, der SMD-Technik, bekannt. Bei elektronischen Schaltungen bestehen jedoch vollkommen andere Anforderungen als im Bereich der Montage mikrooptischer Bauteile, da bei elektronischen Schaltungen geringere Präzisionen erforderlich sind und keine hochgenaue Ausrichtung in allen 6 Freiheitsgraden erforderlich ist. Ausserdem müssen elektronische Schaltungen definitionsgemäss auf unterbrochenen Metallschichten aufgebaut sein, da die Montage einer Vielzahl von elektronischen Bauteilen auf einer Leiterplatte mit einer einzigen ununterbrochenen Metallschicht unzweckmässig wäre. Die vollkommen freie Positionierbarkeit von Bauteilen auf einer Trägerplatte ist bei elektronischen Schaltungen weder erforderlich, noch gewünscht, jedoch beispielsweise für den Aufbau eines mikrooptischen Systems auf einer Trägerplatte von entscheidender Bedeutung. Somit eignen sich Ansätze aus der elektronischen Leiterplatten-Bestückungstechnik nur bedingt.

Aufgabe der vorliegenden Erfindung ist es, ein Verfahren zum Befestigen eines miniaturisierten, insbesondere mindestens ein mikrooptisches Element aufweisenden Bauteils auf einer Grundplatte mittels einer Lötverbindung zur Verfügung zu stellen, das sich durch eine erhöhte Positionsgenauigkeit der Bauteile gegenüber den bekannten Verfahren und eine hohe Wirtschaftlichkeit auszeichnet.

Die Erfindung definiert ein Verfahren gemäß Anspruch 1, eine Grundplatte gemäß Anspruch 15 und ein Substrat gemäß Anspruch 20.

Erfindungsgemäss wird zum Befestigung eines, insbesondere ein mikrooptischen Element aufweisenden, miniaturisierten Bauteils mit seiner Grundfläche auf einer Grundplatte durch eine Lötverbindung die Grundplatte mit einer Metallschicht beschichtet, wobei die Metallschicht stetig flächig aufgebracht und somit unterbrechungsfrei ist. Die Grundplatte und die Metallschicht bilden ein sogenannten Substrat. Ein Lötmaterial wird auf die Metallschicht der Grundplatte aufgebracht. Im Anschluss wird das Bauteil oberhalb der Grundplatte angeordnet, wobei sich das Lötmaterial und die Grundfläche des Bauteils in berührungsfreier, vertikal beabstandeter, einen Zwischenraum bildenden Gegenüberlage befinden. Durch Zuführen von Wärmeenergie in einem lokal, im Wesentlichen auf den Befestigungsabschnitt beschränkten Bereich von der Unterseite der Grundplatte wird das Lötmaterial zum Schmelzen gebracht, so dass sich durch eine Tropfenbildung des geschmolzenen Lötmaterials der Zwischenraum zwischen der Metallschicht und der Grundfläche des Bauteils zur gegenseitigen Befestigung - gegebenenfalls unterstützt durch Absenken des Bauteils - füllt. Durch Erstarren des Lötmaterials wird die gegenseitige Befestigung hergestellt.

Aufgrund der kontinuierlichen, stetig flächigen Metallschicht wird, verglichen zu dem Metallmuster-Verfahren der WO 99/26754, eine wesentlich höhere End-Positionierungsgenauigkeit des Bauteils auf der Grundplatte erreicht, da die durchgehende Metallfläche wesentlich einfachen und homogener mit dem Lötmaterial benetzt wird, als dies bei einer unterbrochenen Metallstruktur der Fall ist.

Ausserdem verursacht der höhere Absorptionskoeffizient der Metallschicht eine Reduzierung der zum Löten erforderlichen Laserstrahlleistung um 40%, verglichen zu dem Verfahren der WO 99/26754. Somit ist eine Laserleistung von weniger als 10 W für 2 Sekunden ausreichend zur Durchführen des Lötung. Durch die Reduzierung der benötigten Leistung sinkt ausserdem die Beschädigungsgefahr der zu befestigenden Bauteile erheblich, insbesondere, wenn es sich um mikrooptische Komponenten handelt, die höchst hitzempfindlich sind. Der Laserstrahl wird wesentlich besser von der Metallschicht absorbiert als bei dem bekannten Verfahren. Daher ist es möglich, Legierungen mit einem höheren Schmelzpunkt zu verwenden. Für das erfindungsgemässe Verfahren muss der Absorptionskoeffizient der Metallschicht nur maximiert werden, um auf unterschiedlichen Typen von Grundplatten ein Löten zu ermöglichen, wohingegen die Lötleistung des Lasers nur der Wärmeausdehnung der Grundplatte angepasst werden muss.

Da im Verfahren der vorliegenden Erfindung eine ununterbrochene, stetig flächige Metallschicht zum Einsatz kommt, ist eine erhebliche Kosteneinsparung bei der Herstellung des Substrats möglich, da eine durchgehende Metallschicht wesentlich einfacher herstellbar ist als ein Metallmuster.

Selbstverständlich ist es nicht erforderlich, dass die stetig flächige Metallschicht auf der gesamten Grundplatte aufgetragen ist. Natürlich ist es möglich, mehrere geschlossene Metallschichten, die miteinander nicht verbunden sind, auf der Grundplatte anzubringen. In demjenigen Befestigungsabschnitt, in welchem das Bauteil mit seiner Grundfläche auf der Grundplatte befestigt werden soll, ist die Metallschicht jedoch im Wesentlichen unterbrechungsfrei und flächig stetig. Es ist es realisierbar, auf einer Grundplatte in einem Muster mehrere Flächenelemente aufzubringen, die jeweils durchgängig und flächig stetig sind, jedoch jedes Flächenelement einen eigenen Befestigungsabschnitt darstellt, auf dem das Bauteil fixiert werden soll, so dass die Projektion der Grundfläche des Bauteils vollkommen von dem einen Flächenelement abgedeckt wird. Mit flächig stetig ist ebenfalls nicht zwangsläufig eine Metallschicht mit absolut gleichmässiger Schichtdicke gemeint, sondern eine im Wesentlichen geschlossene Fläche, die im Wesentlichen keine Unterbrechungen, abgesehen von kleinen Unterbrechungen, die sich insbesondere bei dünnen Schichtdicken ergeben, jedoch nicht künstlich in Form einer Musterstruktur erzeugt werden, aufweist.

In einer Ausführungsform der Erfindung wird das Lötmaterial in Form eines Flachstücks, das beispielsweise die Form eines Zylinderstumpfs aufweist, auf der Metallschicht platziert. Im Anschluss wird das Bauteil mit dessen Grundfläche über dem Lötmaterial angeordnet. Eine Energiequelle, z.B. ein Laser, wird unter der Grundplatte ausgerichtet und gibt einen Energiestrahl von der Unterseite der Grundplatte ab. Der Energiestrahl durchdringt die Grundplatte und trifft auf die Metallschicht auf der Oberseite der Grundplatte. Die Metallschicht wird hierbei lokal begrenzt erhitzt und erwärmt somit, vergleichbar mit einer Herdplatte, das Lötmaterial. Das Lötmaterial-Flachstück schmilzt und nimmt im verflüssigten Zustand aufgrund der Oberflächenspannung des Lots eine tropfenartige Form an. Ausserdem dehnt sich das Lötmaterial aufgrund der Erwärmung um einige Hundert Mikrons aus. Durch die Tropfenform und die Ausdehnung verringert sich der Abstand zwischen dem Lötmaterial und der Grundfläche des Bauteils. Somit kommt es zu einer Benetzung der Grundfläche des Bauteils mit Lötmaterial, so dass eine Lötverbindung herstellbar ist.

Alternativ ist es möglich, den Zwischenraum zwischen der Metallschicht und der Grundfläche des Bauteils durch Absenken des Bauteils von einer Ausgangsposition in Richtung zur Grundplatte zu verringern, so dass die Grundfläche des Bauteils in das geschmolzenen Lötmaterial eintaucht und somit die Grundfläche des Bauteils mit dem Lötmaterial benetzt wird. Gegebenenfalls wird im Anschluss - noch vor dem Einsetzen des Erstarrens - das Bauteil wieder in die Ausgangsposition zurückgefahren. In dieser Ausführungsform, jedoch auch in der ersten, ist es denkbar, das Lötmaterial ebenfalls oder ausschliesslich auf der Grundfläche des Bauteils aufzubringen. Da jedoch eine Erwärmung eines Lötmaterials, das mit der von der Strahlung direkt erwärmten Metallschicht verbundenen ist, effektiver ist, werden bessere Ergebnisse mit einem direkt auf der Metallschicht aufgebrachten Lötmaterial erzielt.

In einer weiteren Ausführungsform der Erfindung ist das Lötmaterial zumindest auf einem Teilbereich der Metallschicht der Grundplatte diskret in Form einer Vielzahl beabstandeter Lötmaterialelemente, beispielsweise in Form eines Punktmusters, oder flächig stetig in Form einer ununterbrochenen Schicht aufgebracht. Dieser Teilbereich ist hierbei wesentlich grösser als der eigentliche Befestigungsabschnitt, den ein einzelnes Bauteil in Anspruch nimmt. Gegebenenfalls ist die gesamte Metallschicht mit dem Lötmaterial beschichtet. Eine Energiequelle, z.B. ein Laser, wird, wie im obigen Verfahren, unter der Grundplatte ausgerichtet ist und gibt einen Energiestrahl von der Unterseite der Grundplatte ab. Der Energiestrahl durchdringt die Grundplatte und trifft auf die Metallschicht. Diese erwärmt sich in einem lokal eng begrenzten Bereich und schmilzt innerhalb dieses Bereich die Lötmaterialschicht oder das Lötmaterialmuster auf. Es kommt in diesem Bereich zu einer Tropfenbildung aufgrund der Oberflächenspannung des Lots. Somit wird, gegebenenfalls durch zusätzliches Absenken des Bauteils, die Grundfläche des Bauteils mit Lötmaterial benetzt, so dass eine Lötverbindung herstellbar ist.

In einer anderen Ausführungsform der Erfindung wird ein Lötmaterial in Form eines insbesondere zylinderstumpfförmigen Flachstücks auf der Grundplatte angeordnet, wobei der Querschnitt des Flachstücks kleiner als der Querschnitt der Grundfläche des Bauteils ist, so dass die Projektion der Grundfläche des Bauteils auf die Metallschicht der Grundplatte den Querschnitt des Flachstücks - vor dem Schmelzen - vollkommen abdeckt. Durch die Reduzierung des Querschnitts des Flachstücks ist eine noch höhere Befestigungsgenauigkeit erzielbar.

Mit dem erfindungsgemässen Lötverfahren werden Befestigungsgenauigkeiten im Bereich von 0,25 Mikron erreicht, so dass sich dieses Verfahren hervorragend zur hochpräzisen Montage von mikrooptischen Komponenten auf einer Grundplatte eignet.

Im Folgenden wird das Verfahren detailliert beschrieben. Im Anschluss erfolgt eine Darstellung der Erfindung durch konkrete Ausführungsbeispiele anhand von Figuren.

Die Grundfläche des miniaturisierten Bauteils muss eine gute Benetzbarkeit für Lötmaterial aufweisen. Diese Grundfläche kann flach oder konvex gestaltet sein, beispielsweise in Form eines konvexen Kugeloberflächenabschnitts oder eines konvexen Zylindermantelflächenabschnitts. Eine sphärische Grundfläche vereinfacht aufgrund der Symmetrie ein exaktes Ausrichten des Bauteils. Durch eine rotationssymmetrische Lötverbindung zwischen der Grundplatte und dem Bauteil wird eine stabile, im Falle einer Schrumpfung verzugsarme Verbindung mit guter Wiederholbarkeit erreicht. Dies erhöht die Prozesssicherheit und ist besonders für eine Serienfertigung von Bedeutung.

Da die Energiezufuhr von derjenigen Seite der Grundplatte erfolgt, die der mit der Metallschicht beschichteten Seite gegenüber liegt, und somit die Energiezufuhr zum Erwärmen der Metallschicht durch die Grundplatte hindurch erfolgt, ist es erforderlich, ein Grundplatte zu wählen, die im Wesentlichen transparent für die Wellenlänge der aufgebrachten Energie ist. Wird ein Laserstrahl als Energiequelle verwendet, so sollte die Grundplatte eine hohe Transparenz für die Laserstrahlenwellenlänge aufweisen.

Ausserdem müssen der Wärmeausdehnungskoeffizienten der Grundplatte und der Metallschicht insofern korrespondieren, als dass es zu keinem Aufreissen oder Aufwellen des Metallschicht während oder nach dem Zuführen der Energie kommen sollte. Im Idealfall ist der Wärmeausdehnungskoeffizient der Grundplatte gleich dem der Metallschicht. Das zur Herstellung der Grundplatte verwendete Material sollte hohen thermischen Belastungen standhalten können, da beim Zuführen der Energie, beispielsweise mittels Laser oder UV, ein Teil der durch die Grundplatte geleiteten Energie zwangsläufig von der Grundplatte absorbiert wird. Ausserdem kommt es in einem Bereich der Metallschicht, die eine hohe Leitfähigkeit aufweist, zu einer starken Erhitzung, weshalb auch die Grundplatte in einem lokal begrenzten Bereich stark aufheizt. Handelt es sich bei der Grundplatte um ein Material mit schlechter Wärmeleitfähigkeit, beispielsweise Glas, Keramik oder Glaskeramik, so kommt es zu einer hohen Energiekonzentration in dem lokal begrenzten Bereich. Dies könnte im Falle einer ungeeigneten Materialwahl zum Versagen des Materials führen. Ist die gegenseitige Ausrichtung mehrerer Bauteile von Bedeutung, so ist ausserdem zu beachten, dass als Grundplatte kein Material gewählt werden sollte, das einen grossen Wärmeausdehnungskoeffizienten besitzt, da sich im Falle einer Erwärmung der Grundplatte die Ausrichtung der optischen Komponenten ändert. Dies würde zwangsläufig zu optischen Fehlern im optischen System führen. Geeignete Materialen für die Grundplatte sind beispielsweise Glas, Saphir, Keramik, Glaskeramik, Silizium oder Pyrex. Weitere geeignete Materialien sind aus dem Stand der Technik bekannt.

Die Metallschicht kann von mehreren Schichten unterschiedlicher Metalle und Legierungen gebildet werden und gegebenenfalls mit einem Antioxidationsmittel, Flussmittel, etc. beschichtet sein. Vorzugsweise sollte die Legierung der Metallschicht oxidationsarm sein und Gold enthalten.

In einer Ausführungsform der Erfindung wird als Grundplatte ein Saphirstück oder ein Pyrex-Wafer mit einer Dicke von etwa 1 bis 2 Millimeter gewählt. Der Wafer ist mit einer Metallschicht aus Chrom, Nickel und Gold beschichtet. Die Metallschicht hat eine Dicke von zirka 1 Mikron. Als Lötmaterial wird z.B. SnPb oder Sn96Ag4 gewählt, das einen Spalt zwischen der Metallschicht und der Grundfläche des Bauteils von 0,2 bis 0,5 Millimeter füllt.

Das Schrumpfen des Lötmaterials während des Abkühlens sorgt zwangsläufig für einen vertikalen Versatz des Bauteils senkrecht zur Grundplatte. Es besitzt eine gute Wiederholbarkeit und bildet ein Funktion aus dem Spalt zwischen der Grundplatte und der Grundfläche des Bauteils. Zur Kompensation dieser vertikalen Schrumpfung ist es möglich, das Bauteil entsprechend höher zu positionieren und die Schrumpfung beim Vorpositionieren zu berücksichtigen.

In einer weiteren Ausführungsform der Erfindung wird die Montagegenauigkeit dadurch weiter erhöht, dass, vor allem im Falle eines geneigten Bauteils, der Querschnitt des Lötmaterials, beispielsweise der Durchmesser des Flachstücks, verringert wird, so dass dieser Querschnitt kleiner als der der Grundfläche des Bauteils ist. In diesem Fall ist der Durchmesser d des Lötmaterial-Flachstücks kleiner als der Durchmesser D der Grundfläche des Bauteils. Spätestens nach dem Erstarren des Lötmaterials ist der Durchmesser des erstarrten Lötmaterials kleiner als der Durchmesser D der Grundfläche. Hierdurch ergeben sich geringere Asymmetrien beim Erstarren des Lötmaterials, die sich besonders aufgrund der Tatsache ergeben können, dass das Lötmaterial an den Querflächen wesentlich schneller abkühlt als in der Mitte. Vor allem bei einer geneigten Montage eines Bauteils ist es daher von Vorteil, eine Lötverbindung mit wenig Lötmaterial zu schaffen, da sich in diesem Fall Schrumpfungen nicht dermassen auswirken. Ausserdem treten in diesem Fall weniger Spannungen auf, die sich durch die Abkühlung und das damit verbundene Schrumpfen ergeben, so dass sich die Fertigungsgenauigkeit weiter erhöht.

Das Verfahren eignet sich vor allem zur Anwendung in einem automatischen, flussmittelfreien Laserlötprozess, da im Wesentlichen alle erforderlichen Schritte von Handhabungsrobotern, die über ein hochgenaue Positionssensorik verfügen, durchgeführt werden können. So kann jedes Bauteil frei im Raum hochpräzise in allen 6 Freiheitsgraden positioniert werden. Die freie Positionierbarkeit, die sich nicht zwangsläufig durch vorgegebene Bereiche auf der Grundplatte beschränkt, ist ein weiterer Vorteil der Erfindung. Ist die gesamte Grundplatte mit der Metallschicht beschichtet, so besteht die Möglichkeit, entweder durch freies Positionieren eines Lötmaterialflachstücks oder im Falle einer Lötmaterialschicht das Bauteil in einer beliebigen Position auf der Grundplatte zu positionieren.

Diese hier beschriebene Technik eignet sich vor allem zum hochgenauen, in allen 6 Freiheitsgranden ausgerichteten Befestigen mikrooptischer Komponenten. So kann das miniaturisierte Bauteil als Halterung für ein mikrooptisches Element, z.B. einer Linse, einer optischen Faser, einer Laserdiode, etc., dienen. Solche mikrooptischen Bauteile haben typischerweise einen Durchmesser in der Grössenordnung von 2,6 mm und eine Höhe von 3,5 mm. Ein mögliches Beispiel einer Haltevorrichtung für ein mikrooptisches Bauteil ist der EP 1127287 B1 zu entnehmen.

Eine weitere Ausführungsform der Erfindung stellt eine Grundplatte gemäß Anspruch 15. Die Bauteile sind mit der Grundfläche über jeweils eine Lötverbindung auf der Metallschicht befestigt. Die Grundplatte ist transparent für Laserstrahlung. Der Bauteilbereich ist ein Teilbereich der Grundplatte, auf dem mehrere Teile auf der zusammenhängenden Metallschicht angeordnet sind. In einer möglichen Ausführungsform ist die Metallschicht im Wesentlichen auf der gesamten Oberseite der Grundplatte stetig flächig aufgebracht und somit im Wesentlichen unterbrechungsfrei. In diesem Fall wird der Bauteilbereich von der gesamten Grundplatte gebildet. Das Lötmaterial der Lötverbindung weist bevorzugt eine konkave Aussenfläche auf.

In einer speziellen Ausführungsform umfasst mindestens eines der mehreren Bauteile eine Halterung zum Halten eines Stützteils, an dem das jeweils mindestens eine mikrooptische Element fixiert ist, wobei die Halterung mit dem Stützteil und das Stützteil mit dem mikrooptischen Element mittels Lötpunkten verbunden sind. Eine solche Halterung wird auch in der EP 1127287 B1 beschrieben.

Das Substrat zur Verwendung in dem erfindungsgemässen Verfahren ist im Anspruch 20 definiert.

Die Erfindung wird nachfolgend anhand von in den Zeichnungen schematisch dargestellten konkreten Ausführungsbeispielen näher beschrieben. Im Einzelnen zeigen:
- Fig. 1a, 1b: die Anordnung eines Bauteils, eines als kleines Flachstück ausgebildeten Lötmaterials und eines Substrats vor (Fig. 1a) und nach (Fig. 1b) dem Herstellen der Lötverbindung;
- Fig. 2a, 2b: die Anordnung eines Bauteils, eines als grosses Flachstück ausgebildeten Lötmaterials und eines Substrats vor (Fig. 2a) und nach (Fig. 2b) dem Herstellen der Lötverbindung;
- Fig. 3: die Bestimmung des Durchmessers d eines als Flachstück ausgebildeten Lötmaterials bei einer Bauteilneigung von αₘₐₓ = ± 5° ;
- Fig. 4a, 4b: ein Bauteil und ein Substrat mit einer in einem Musters aus einer Vielzahl beabstandeter Lötmaterialelemente aufgebrachten Schicht aus Lötmaterial vor (Fig. 4a) und nach (Fig. 4b) dem Herstellen der Lötverbindung;
- Fig. 5a, 5b: ein Bauteil und ein Substrat mit einer stetig flächig aufgebrachten Schicht aus Lötmaterial vor (Fig. 5a) und nach (Fig. 5b) dem Herstellen der Lötverbindung; und
- Fig. 6: ein Bauteil, das eine Halterung zum Halten eines Stützteils, an dem ein mikrooptisches Element fixiert ist, umfasst.

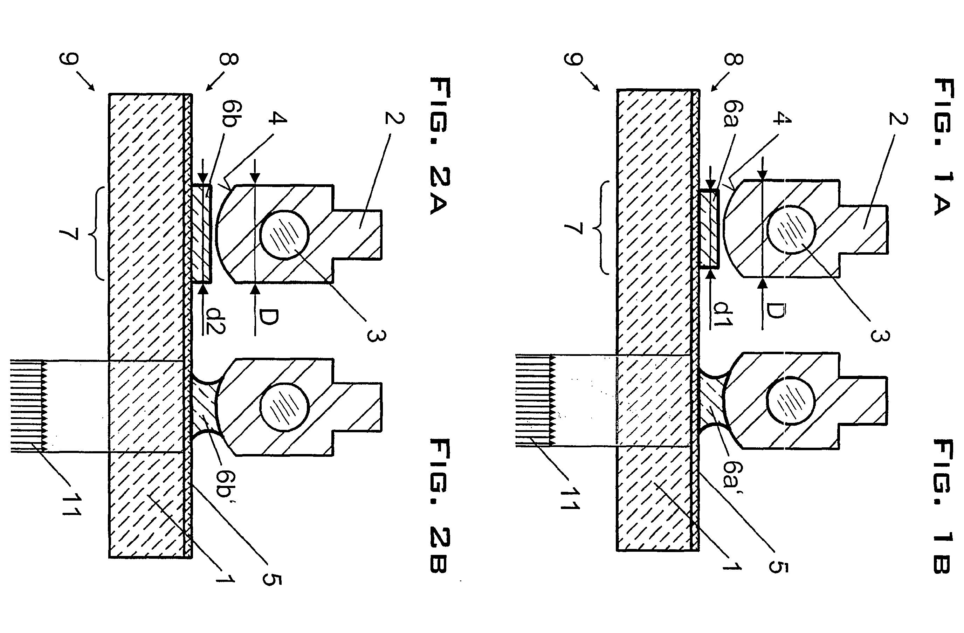

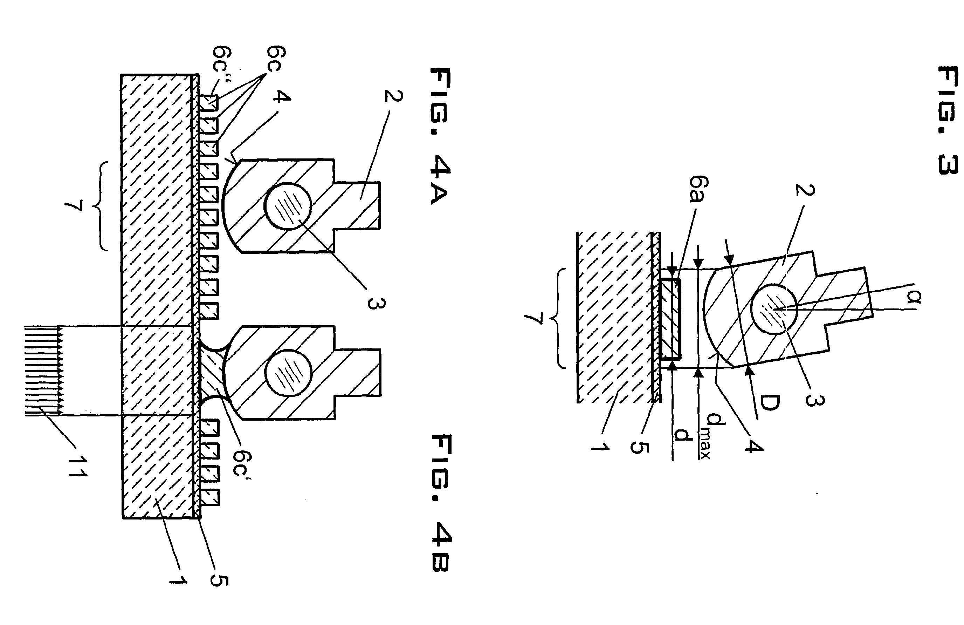

Fig. 1a und Fig. 2a zeigen je eine Grundplatte 1 mit einer Oberseite 8 und einer Unterseite 9 in einem Zustand vor Herstellen einer Lötverbindung. Die für Laserstrahlung transparente Grundplatte 1 ist auf ihrer Oberseite 8 mit einer Metallschicht 5, die stetig flächig aufgebracht ist, so dass sie im Wesentlichen unterbrechungsfrei ist, beschichtet. Die Grundplatte 1 und die Metallschicht 5 bilden ein sogenanntes Substrat. Innerhalb eines Befestigungsabschnitts 7 auf der Metallschicht 5 ist ein Lötmaterial 6a, 6b in Form eines Flachstücks, das im noch nicht geschmolzenen Zustand die Form eines Zylinderstumpfs besitzt, jedoch auch eine andere Form besitzen kann, aufgebracht. Der Befestigungsabschnitt 7 ist derjenige Abschnitt, auf dem ein einzelnes Bauteil 2 befestigt werden soll oder befestigt ist. Oberhalb des Befestigungsabschnitts 7 der Grundplatte 1 ist ein miniaturisiertes Bauteil 2, das ein mikrooptisches Element 3 trägt, so angeordnet, dass sich das Lötmaterial 6a, 6b und eine konvexe Grundfläche 4 des Bauteils 2 in berührungsfreier, vertikal beabstandeter, einen vertikalen Zwischenraum bildenden Gegenüberlage befinden. Das Bauteil 2 wird mittels einer Roboterstation (nicht dargestellt) hochpräzise positioniert und gehalten, wobei die zu erwartende vertikale Schrumpfung berücksichtig wird. In Fig. 1a besitzt das als Flachstück ausgebildete Lötmaterial 6a einen Durchmesser d1, der kleiner ist als der Durchmesser D der Grundfläche 4 des Bauteils 2, so dass gilt dl<D, wohingegen das nicht geschmolzene Lötmaterial 6b in Fig. 2a einen Durchmesser d2 hat, der gleich dem Durchmesser D ist, so dass gilt d2=D.

Durch Zuführen einer auf den Befestigungsabschnitt 7 lokal begrenzten, die Grundplatte 1 durchdringenden Laserstrahlung in Form eines Laserstrahlenbündels 11 von der Unterseite 9 der Grundplatte 1 wird die Metallschicht 5 zumindest innerhalb des Befestigungsabschnitts 7 stark erhitzt und wirkt wie eine Art Herdplatte, so dass das Lötmaterial 6a, 6b schmilz, aufgrund der Oberflächenspannung einen Tropfen bildet, die Grundfläche 4 benetzt, den Zwischenraum schliesst und somit eine Verbindung zwischen der Metallschicht 5 und der Grundfläche 4 schafft. Im Anschluss wir die Laserstrahlung 11 wieder deaktiviert und das Erstarren des geschmolzenen Lötmaterial 6a', 6b' abgewartet. Die Figuren 1b und 2b zeigen den Zustand nach Herstellen dieser Verbindung mit dem geschmolzenen Lötmaterial 6a', 6b'. In beiden Fällen verringert sich durch Schrumpfen des Lötmaterials 6a', 6b' der vertikale Abstand zwischen dem Bauteil 2 und der Grundplatte 1. Ausserdem verringert sich der Durchmesser des geschmolzenen Lötmaterials 6a', 6b' im Vergleich zu dem Durchmesser d1, d2 des ungeschmolzenen Lötmaterials 6a, 6b, wobei sowohl in Fig. 1a für d1<D, als auch in Fig. 2a für d2=D gilt, dass der Durchmesser des geschmolzenen Lötmaterials 6a', 6b' kleiner als D ist. Das geschmolzene Lötmaterial 6a' in Fig. 1b hat hierbei einen kleineren Durchmesser als das geschmolzenen Lötmaterial 6b' in Fig. 2b. Die Seitenfläche des geschmolzenen Lötmaterials 6a', 6b' weist eine konkave Form auf.

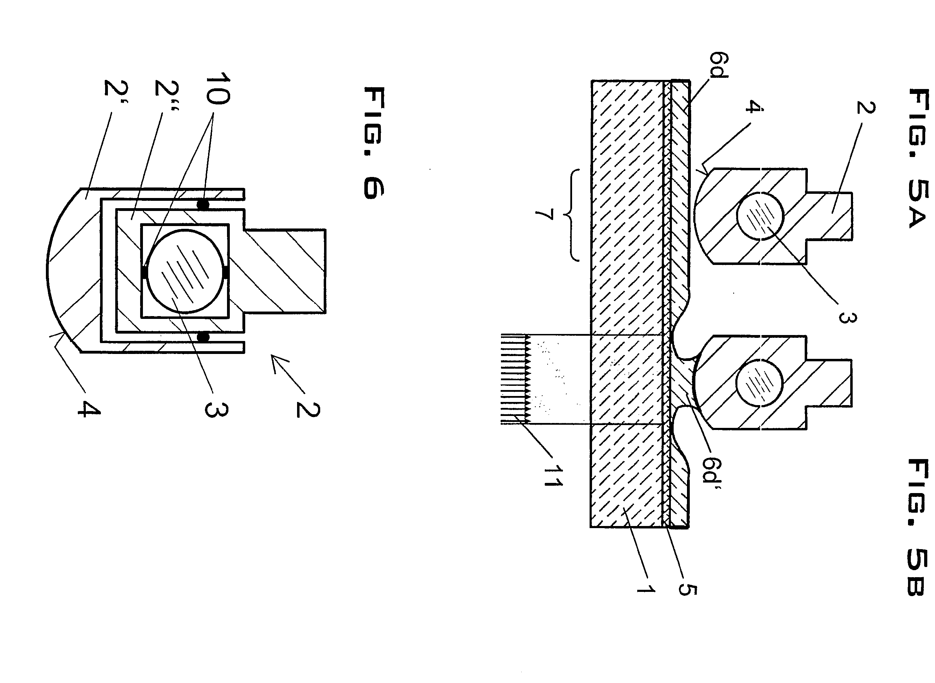

Fig. 3 stellt die Bestimmung des Durchmessers d eines als kleines Flachstück ausgebildeten Lötmaterials 6a bei einer Neigung des Bauteils 2 von αₘₐₓ = ±5°dar. Unter der Annahme, dass der Durchmesser D der Grundfläche 4 des Bauteils 2 beispielsweise gleich D = 2,6 mm, der Radius der Rundung der Grundfläche 4 gleich r = 1,6 mm und der Neigungswinkel des Bauteils 2 gleich αₘₐₓ = ±5°, ergibt sich für den Durchmesser d des als Flachstück ausgebildeten, kontaktierenden Lötmaterials 6a ein maximaler Durchmesser von dₘₐₓ = 2,43 mm. Der ideale Abstand ergibt sich aus dem Erfordernis, dass das Lötmaterial 6a vor Herstellen der Verbindung nicht die Grundfläche 4 kontaktieren sollte, und dies selbst im Falle eines geneigten Bauteils 2. Um dieses Erfordernis zu erfüllen, wird der Durchmesser d des kleinen Flachstücks aus Lötmaterial 6a um 20% gegenüber dₘₐₓ reduziert, so dass sich ergibt d = 2,43 * (1 - 0,2) = 1,94 mm.

In Fig. 4a und 4b wird ein Bauteil 2 und ein Substrat aus Grundplatte 1 und Metallschicht 5 mit einer, in einem Musters aus einer Vielzahl beabstandeter Lötmaterialelemente 6c" aufgebrachten Schicht aus Lötmaterial 6c vor (Fig. 4a) und nach (Fig. 4b) dem Herstellen der Lötverbindung gezeigt. Die musterförmige Lötmaterialschicht 6c ist auf der gesamten Metallschicht 5 aufgebracht. Ein lokal begrenzter Laserstrahl 11 schmilzt mehrere Lötmaterialelemente 6c" der Lötmaterialschicht 6c zu einem Tropfen aus Lötmaterial 6c' zusammen, der wie in Fig. 1a/1b und 2a/2b die Verbindung zwischen der Grundfläche 4 des Bauteils 2 und der Metallschicht 5 der Grundplatte 1 schafft. In Fig. 5a und 5b wird hingegen ein Bauteil 2 und ein Substrat mit einer stetig flächig aufgebrachten Schicht aus Lötmaterial 6d vor (Fig. 5a) und nach (Fig. 5b) dem Herstellen der Lötverbindung gezeigt. Ein Laserstrahl 11 schmilzt hierbei einen Teil des Lötmaterials 6d, der sich zu einem Tropfen aus Lötmaterial 6d' formt und die Verbindung zwischen dem Bauteil 2 und der Grundplatte 1 herstellt.

Fig. 6 zeigt eine Ausführungsform eines Bauteils 2, das eine Halterung 2' zum Halten eines Stützteils 2", an dem ein mikrooptisches Element 3 fixiert ist, umfasst, wobei die Halterung 2' mit dem Stützteil 2" und das Stützteil 2" mit dem mikrooptischen Element 3 mittels Lötpunkten 10 verbunden sind. Zur Ermöglichung einer Lötverbindung besitzt das Bauteil 2 eine Grundfläche 4.

## Patentansprüche

1. Verfahren zur hochpräzisen, frei positionierbaren Befestigung eines miniaturisierten Bauteils (2), insbesondere mit einem mikrooptischen Element (3), auf einem vorgegebenen Befestigungsabschnitt (7) einer Grundplatte (1) durch eine Lötverbindung, wobei
• die Grundplatte (1) ein Oberseite (8) und eine Unterseite (9) und das Bauteil (2) eine Grundfläche (4) aufweist,
• zumindest der Befestigungsabschnitt (7) der Grundplatte (1) auf der Oberseite (8) mit mindestens einer Metallschicht (5) beschichtet ist, und
• Lötmaterial (6a, 6b, 6c, 6d) zumindest auf dem mit der Metallschicht (5) beschichteten Befestigungsabschnitt (7) der Grundplatte (1) wenigstens teilweise aufgebracht ist,
mit den Schritten
• hochpräzises Anordnen des Bauteils (2) oberhalb des Befestigungsabschnitts (7) der Grundplatte (1), wobei sich das Lötmaterial (6a, 6b, 6c, 6d) und die Grundfläche (4) des Bauteils (2) in berührungsfreier, vertikal beabstandeter, einen Zwischenraum bildenden Gegenüberlage befinden,
• Zuführen von Wärmeenergie in einem lokal, im Wesentlichen auf den Befestigungsabschnitt (7) beschränkten Bereich zum zumindest teilweisen Schmelzen des Lötmaterials (6a, 6b, 6c, 6d) von der Unterseite (9) der Grundplatte (1), so dass sich durch eine Tropfenbildung des geschmolzenen Lötmaterials (6a', 6b', 6c', 6d') der Zwischenraum zur gegenseitigen Befestigung füllt, und
• Warten auf die gegenseitige Befestigung,
wobei die Metallschicht (5) auf der Oberseite (8) der Grundplatte (1) zumindest in dem Befestigungsabschnitt (7) stetig flächig aufgebracht und somit im Befestigungsabschnitt (7) unterbrechungsfrei ist.

2. Verfahren nach Anspruch 1, wobei
wobei die Metallschicht (5) im Wesentlichen auf der gesamten Oberseite (8) der Grundplatte (1) stetig flächig aufgebracht und somit im Wesentlichen auf der gesamten Oberseite (8) der Grundplatte (1) unterbrechungsfrei ist.

3. Verfahren nach Anspruch 1 oder 2, wobei der Schritt des Zuführens von Wärmeenergie folgenden Teilschritte umfasst:
• Zuführen von Wärmeenergie in einem lokal, im Wesentlichen auf den Befestigungsabschnitt (7) beschränkten Bereich zum Schmelzen des Lötmaterials (6a, 6b, 6c, 6d) von der Unterseite (9) der Grundplatte (1) und
• Verringern des Zwischenraum zwischen dem geschmolzenen - Lötmaterial (6a', 6b', 6c', 6d') und der Grundfläche (4) des Bauteils (2) durch Absenken des Bauteils (2) von einer Ausgangsposition in Richtung zur Grundplatte (1), so dass die Grundfläche (4) des Bauteils (2) in das geschmolzenen Lötmaterial (6a', 6b', 6c', 6d') eintaucht und die Grundfläche (4) des Bauteils (2) benetzt wird.

4. Verfahren nach Anspruch 3, mit dem weiteren Teilschritt:
• Zurückpositionieren des Bauteils (2) in die Ausgangsposition.

5. Verfahren nach einem der Ansprüche 1 bis 4, wobei das Zuführen von Wärmeenergie von der Unterseite (9) der Grundplatte (1) durch ein auf den Befestigungsabschnitt (7) gerichtetes, die Metallschicht (5) erwärmendes und somit das Lötmaterial (6a, 6b, 6c, 6d) schmelzendes Strahlenbündel elektromagnetischer Wellen erfolgt.

6. Verfahren nach Anspruch 5, wobei
• das Strahlenbündel ein Laserstrahlenbündel (11) ist und
• die Grundplatte (1) transparent für Laserstrahlung ist.

7. Verfahren nach einem der Ansprüche 1 bis 6, wobei
die Grundfläche (4) des Bauteils konvex ist.

8. Verfahren nach Anspruch 7, wobei
die Grundfläche (4) des Bauteils die Form eines konvexen Kugeloberflächenabschnitts besitzt.

9. Verfahren nach Anspruch 7, wobei
die Grundfläche (4) des Bauteils die Form eines konvexen Zylindermantelflächenabschnitts besitzt.

10. Verfahren nach einem der Ansprüche 1 bis 9, wobei
das Lötmaterial (6a, 6b) derart zumindest auf dem mit der Metallschicht (5) beschichteten Befestigungsabschnitt (7) der Grundplatte (1) aufgebrachte ist, dass im noch nicht geschmolzenen Zustand des Lötmaterials (6a, 6b) die auf die Oberseite der Grundplatte projizierte Grundfläche (4) des Bauteils (2) die Querschnittsfläche des Lötmaterials (6a, 6b) vollkommen überdeckt.

11. Verfahren nach einem der Ansprüche 1 bis 10, wobei
das Lötmaterial (6a, 6b) derart zumindest auf dem mit der Metallschicht (5) beschichteten Befestigungsabschnitt (7) der Grundplatte (1) aufgebrachte ist, dass es im noch nicht geschmolzenen Zustand eine Flachstückform, insbesondere die eines flachen Zylinderstumpfs, aufweist.

12. Verfahren nach einem der Ansprüche 1 bis 9, wobei
das Lötmaterial (6c, 6d) in einem den Befestigungsabschnitt (7) enthaltenden Bereich auf der Metallschicht (5) aufgebracht ist, wobei der Bereich wesentlich grösser als der darin enthaltene Befestigungsabschnitt (7) ist.

13. Verfahren nach Anspruch 12, wobei das Lötmaterial (6d) in dem Bereich auf der Metallschicht (5) der Grundplatte (1) stetig flächig aufgebracht und somit in dem Bereich unterbrechungsfrei ist.

14. Verfahren nach Anspruch 12, wobei das Lötmaterial (6c) in dem Bereich auf der Metallschicht (5) der Grundplatte (1) in einem Musters aus einer Vielzahl beabstandeter Lötmaterialelemente (6c") aufgebracht ist.

15. Grundplatte (1) mit mehreren, innerhalb eines Bauteilbereichs der Grundplatte (1) hochpräzise, frei positioniert angeordneten, miniaturisierten Bauteilen (2), die jeweils mindestens ein mikrooptisches Element (3) aufweisen, wobei
• die Grundplatte (1) ein Oberseite (8) und die Bauteile (2) jeweils eine Grundfläche (4) aufweisen,
• zumindest der Bauteilbereich der Grundplatte (1) auf der Oberseite (8) mit mindestens einer Metallschicht (5) beschichtet ist,
• die Bauteile (2) mit der Grundfläche (4) über jeweils eine Lötverbindung auf der Metallschicht (5) befestigt sind und
• die Grundplatte (1) transparent für Laserstrahlung ist,
**dadurch gekennzeichnet, dass**
die Metallschicht (5) auf der Oberseite (8) der Grundplatte (1) zumindest in dem Bauteilbereich stetig flächig aufgebracht und somit im Bauteilbereich unterbrechungsfrei ist.

16. Grundplatte (1) nach Anspruch 15,
**dadurch gekennzeichnet, dass**
die Metallschicht (5) im Wesentlichen auf der gesamten Oberseite (8) der Grundplatte (1) stetig flächig aufgebracht und somit im Wesentlichen auf der gesamten Oberseite (8) der Grundplatte (1) unterbrechungsfrei ist.

17. Grundplatte (1) nach Anspruch 15 oder 16,
**dadurch gekennzeichnet, dass**
das Lötmaterial (6a', 6b', 6c', 6d') der Lötverbindung eine konkave Aussenfläche aufweist.

18. Grundplatte (1) nach einem der Ansprüche 15 bis 17,
**dadurch gekennzeichnet, dass**
die Grundfläche (4) des Bauteils (2) konvex ist.

19. Grundplatte (a) nach einem der Ansprüche 15 bis 18,
**dadurch gekennzeichnet, dass**
mindestens eines der mehreren Bauteile (2) eine Halterung (2') zum Halten eines Stützteils (2''), an dem das jeweils mindestens eine mikrooptische Element (3) fixiert ist, umfasst, wobei die Halterung (2') mit dem Stützteil (2") und das Stützteil (2") mit dem mikrooptischen Element (3) mittels Lötpunkten (10) verbunden sind.

20. Substrat zur Verwendung in dem Verfahren nach einem der Ansprüche 1 bis 14, das folgende Merkmale aufweist :
• eine für Laserstrahlung transparente Grundplatte (1),
• mindestens eine Metallschicht (5) und
• eine Schicht aus Lötmaterial (6c),
wobei die Grundplatte (1) auf einer Seite (8) mit der mindestens einen Metallschicht (5) beschichtet ist, die Metallschicht (5) im Wesentlichen auf der gesamten Seite (8) der Grundplatte (1) stetig flächig aufgebracht und somit im Wesentlichen auf der gesamten Seite (8) der Grundplatte (1) unterbrechungsfrei ist und die Schicht aus Lötmaterial (6c) zumindest auf einen Teilbereich der Metallschicht (5) der Grundplatte (1) in einem Muster aus einer Vielzahl beabstandeter Lötmaterialelemente (6c") aufgebracht ist.

21. Substrat nach Anspruch 20,
**dadurch gekennzeichnet, dass**
die Schicht aus Lötmaterial (6c, 6d) auf der gesamten Metallschicht (5) aufgebracht ist.

## Claims

1. Method for highly precise, freely positionable fixing of a miniaturized component (2), in particular comprising a micro-optical element (3) to specified fixing section (7) of a base plate (1) by a solder joint,
• base plate (1) having a top (8) and a bottom (9) and the component (2) having a base surface (4),
• at least the fixing section (7) of the base plate (1) being coated on the top (8) with at least one metal layer (5), and
• solder material (6a, 6b, 6c, 6d) being applied at least partly at least to that fixing section (7) of the base plate (1) which is coated with the metal layer (5),
comprising the steps
• highly precise arrangement of the component (2) above the fixing section(7) of the base plate (1), the solder material (6a, 6b, 6c, 6d) and the base surface (4) of the component (2) being in positions opposite one another, without contact, vertically distanced apart, and forming an intermediate space,
• supply of heat energy in a region limited locally and substantially to the fixing section (7) for at least partial melting of the solder material (6a, 6b, 6c, 6d) from the bottom (9) of the base plate (1), so that the intermediate space is filled by drop formation of the molten solder material (6a', 6b', 6c', 6d') for mutual fixing, and
• waiting for the mutual fixing, the metal layer (5) on the top (8) of the base plate (1) being applied continuously over the whole area at least in the fixing section (7) and thus being without interruption in the fixing section (7).

2. Method according to Claim 1, the metal layer (5) being applied continuously over the whole area substantially on the entire top (8) of the base plate (1) and thus being substantially without interruption on the entire top (8) of the base plate (1).

3. Method according to Claim 1 or 2, the step consisting of the supply of heat energy comprising the following partial steps:
• supply of heat energy in a region limited locally and substantially to the fixing section (7) for melting the solder material (6a, 6b, 6c, 6d) from the bottom (9) of the base plate (1) and
• reduction of the intermediate space between the molten solder material (6a', 6b', 6c', 6d') and the base surface (4) of the component (2) by lowering the component (2) from a starting position towards the base plate (1) so that the base surface (4) of the component (2) dips into the molten solder material (6a', 6b', 6c', 6d') and the base surface (4) of the component (2) is wetted.

4. Method according to Claim 3, comprising the further partial step:
• repositioning of the component (2) to the starting position.

5. Method according to any of Claims 1 to 4, supply of heat energy being effected from the bottom (9) of the base plate (1) by a beam of electromagnetic waves which is directed onto the fixing section, heats the metal layer (5) and thus melts the solder material (6a, 6b, 6c, 6d).

6. Method according to Claim 5,
• the beam being a laser beam (11) and
• the base plate (1) being transparent to laser radiation.

7. Method according to any of Claims 1 to 6, the base surface (4) of the component being convex.

8. Method according to Claim 7, the base surface (4) of the component having the shape of a convex spherical surface section.

9. Method according to Claim 7, the base surface (4) of the component having the shape of a convex lateral cylinder surface section.

10. Method according to any of Claims 1 to 9, the solder material (6a, 6b), being applied, at least to that fixing section (7) of the base plate (1) which is coated with the metal layer (5) in such a way that, when the solder material (6a, 6b) is not yet in the molten state, the base surface (4) of the component (2) which is projected onto the top of the base plate completely covers the cross sectional area of the solder material (6a, 6b).

11. Method according to any of Claims 1 to 10, the solder material (6a, 6b) being applied, at least to that fixing section (7) of the base plate (1) which is coated with the metal layer (5), in such a way that, in the state in which it is still not molten, it has the shape of a flat piece, in particular that of a flat truncated cylinder.

12. Method according to any of Claims 1 to 9, the solder material (6c, 6d) being applied to the metal layer (5) in a region containing the fixing section (7), the region being substantially larger than the fixing section (7) present therein.

13. Method according to Claim 12, the solder material (6d) being applied continuously over the whole area in the region of the metal layer (5) of the base plate (1) and thus being without interruption in the region.

14. Method according to Claim 12, the solder material (6c) being applied in the region on the metal layer (5) of the base plate (1) in a pattern comprising a large number of solder elements (6c") a distance apart.

15. Base plate (1) having a plurality of miniaturized components (2) which are arranged highly precisely and freely positioned within a component region of the base plate (1) and in each case have at least one microoptical element (3),
• the base plate (1) having a top (8) and the components (2) each having a base surface (4),
• at least the component region of the base plate (1) being coated on the top (8) with a metal layer (5),
• the components (2) being fastened to the base surface (4) via in each case one solder joint on the metal layer (5) and
• the base plate (1) being transparent to laser radiation,
**characterized in that** the metal layer (5) is applied continuously over the whole area at least in the component region on the top (8) of the base plate (1) and is thus without interruption in the component region.

16. The base plate (1) according to Claim 15, **characterized in that** the metal layer (5) is applied continuously over the whole area substantially on the entire top (8) of the base plate (1) and is thus substantially without interruption on the entire top (8) of the base plate (1).

17. The base plate (1) according to Claim 15 or 16, **characterized in that** the solder material (6a', 6b', 6c', 6d') of the solder joint has a concave outer surface.

18. The base plate (1) according to any of Claims 15 to 17, **characterized in that** the base surface (4) of the component (2) is convex.

19. The base plate (1) according to any of Claims 15 to 18, **characterized in that** at least one of the plurality of components (2) comprises a holder (2') for holding a support part (2") to which the at least one microoptical element (3) in each case is fixed, the holder (2") being connected to the support part (2") and the support part (2") being connected to the microoptical element (3) by means of solder spots (10).

20. Substrate for use in the method according to any of Claims 1 to 14, which has the following features:
• a base plate (1) transparent to laser radiation,
• at least one metal layer (5) and
• a layer of solder material (6c),
the base plate (1) being coated on one side (8) with the at least one metal layer (5), the metal layer (5) being applied continuously over the whole area substantially on the entire side (8) of the base plate (1) and thus being without interruption substantially on the entire side (8) of the base plate (1) and the layer of solder material (6c) being applied, at least on a partial region of the metal layer (5) of the base plate (1), in a pattern comprising a large number of solder material elements (6c") a distance apart.

21. Substrate according to Claim 20, **characterized in that** the layer of solder material (6c, 6d) is applied on the entire metal layer (5).

## Revendications

1. Procédé de fixation de haute précision, pouvant être positionné librement, d'un composant (2) miniaturisé, en particulier avec un élément micro-optique (3), sur un tronçon de fixation (7) prédéterminé et une plaque de base (1), au moyen d'une liaison brasée, où
• La plaque de base (1) présente une face supérieure (8) et une face inférieure (9) et le composant (2) présente une face de base (4),
• au moins le tronçon de fixation (7) de la plaque de base (1) est enduit, sur la face supérieure (8), d'au moins une couche métallique (5), et
• le matériau de brasage (6a, 6b, 6c, 6d) est appliqué, au moins partiellement, au moins sur le tronçon de fixation (7) enduit de la couche métallique (5),
comprenant les étapes suivantes
• agencement de haute précision du composant (2) au-dessus du tronçon de fixation (7) de la plaque de base (1), le matériau de brasage (6a, 6b, 6c, 6d) et la face de base (4) du composant (2) se trouvant en confrontation de contact, avec un espacement vertical, formant un espace intermédiaire,
• amenée d'énergie thermique dans une zone limitée localement, essentiellement au tronçon de fixation (7), pour produire au moins partiellement la mise en fusion du matériau de brasage (6a, 6b, 6c, 6d) depuis la face inférieure (9) de la plaque de base (1), de sorte que par une formation de gouttes du matériau de brasage (6a',6b',6c',6d') fondu, l'espace intermédiaire soit rempli, pour produire une fixation mutuelle, et
• attente de la fixation mutuelle,
où la couche métallique (5) sur la face supérieure (8) de la plaque de base (1) est appliquée continûment en surface, au moins dans le tronçon de fixation (7), et est ainsi exempte d'interruption dans le tronçon de fixation (7).

2. Procédé selon la revendication 1, la couche métallique (5) étant appliquée en permanence en surface, essentiellement sur l'ensemble de la face supérieure (8) de la plaque de base (1), et étant ainsi sensiblement exempte d'interruption sur l'ensemble de la face supérieure (8) de la plaque de base (1).

3. Procédé selon la revendication 1 ou 2, l'étape d'amenée d'énergie thermique comprenant les étapes partielles suivantes :
• amenée d'énergie thermique dans une zone limitée localement essentiellement au tronçon de fixation (7), pour mettre en fusion le matériau de brasage (6a, 6b, 6c, 6d) depuis la face inférieure (9) de la plaque de base (1), et
• diminution de l'espace intermédiaire entre le matériau de brasage (6a',6b',6c',6d') fondu et la plaque de base (4) du composant (2), par abaissement du composant (2), d'une position initiale en direction de la plaque de base (3), de sorte que la face de base (4) du composant (2) pénètre dans le matériau de brasage (6a',6b',6c',6d') fondu et que la face de base (4) du composant (2) soit mouillée.

4. Procédé selon la revendication 3, présentant l'étape partielle suivante ci-après :
• repositionnement du composant (2) à la position initiale.

5. Procédé selon l'une des revendications 1 à 4, l'amenée d'énergie thermique depuis la face inférieure (9) de la plaque de base (1) s'effectuant au moyen d'un faisceau de rayons, d'ondes électromagnétiques, dirigé à travers le tronçon de fixation (7), chauffant la couche métallique (5) et, ainsi, portant à fusion le matériau de brasage (6a, 6b, 6c, 6d).

6. Procédé selon la revendication 5, dans lequel :
• le faisceau de rayon est un faisceau de rayon laser (11), et
• la plaque de base (1) est transparente au rayonnement laser.

7. Procédé selon l'une des revendications 1 à 6, la face de base du composant étant convexe.

8. Procédé selon la revendication 7, la face de base (4) du composant ayant la forme d'un tronçon de surface sphérique convexe.

9. Procédé selon la revendication 7, la face de base (4) du composant présentant la forme d'un tronçon de surface d'enveloppe cylindrique convexe.

10. Procédé selon l'une des revendications 1 à 9, le matériau de brasage (6a, 6b) étant appliqué, au moins sur le tronçon de surface (7), enduit par la couche métallique (5) de la plaque de base (1), de manière que, à l'état non encore fondu du matériau de base (6a, 6b), la face de base (4), projetée sur la face supérieure de la plaque de base, du composant recouvre complètement la face de section transversale du matériau de brasure (6a, 6b).

11. Procédé selon l'une des revendications 1 à 10, le matériau de brasage (6a, 6b) étant appliqué au moins sur le tronçon de fixation (7), enduit par la couche métallique (5), de la plaque de base (1) de manière que, à l'état non encore fondu, il présente une forme de pièce plate, en particulier la forme d'un tronçon de cylindre plat.

12. Procédé selon l'une des revendications 1 à 9, le matériau de brasage (6c, 6d) étant appliqué dans une zone, contenant le tronçon de fixation (7), sur la couche métallique (5), la zone étant sensiblement supérieure au tronçon de fixation (7) y étant contenu.

13. Procédé selon la revendication 12, le matériau de brasage (6d) étant appliqué de façon continûment en surface dans la zone située sur la couche métallique (5) de la plaque de base (1) et, ainsi, étant sans interruption dans la zone.

14. Procédé selon la revendication 12, le matériau de brasage (6c) étant appliqué dans la zone située sur la couche métallique (5) de la plaque de base (1), en un motif formé d'une pluralité d'éléments de matériau de brasage (6c") espacés les uns des autres.

15. Plaque de base (1) comprenant une pluralité de composants (2) miniaturisés de haute précision, à l'intérieur de la zone de composant de la plaque de base (1), et disposés en étant positionnés librement, les composants présentant chacun au moins un élément (3) micro-optique, où
• la plaque de base (1) présente une face supérieure (8) et les composants (2) présentent chacun une face de base (4),
• au mois la zone de composant de la plaque de base (1), sur la face supérieure (8), est enduite d'au moins une couche métallique (5),
• les composants (2) étant fixés sur la couche métallique (5) par la face de base (4), par l'intermédiaire chaque fois d'une liaison brasée, et
• la plaque de base (1) est transparente au rayonnement laser
**caractérisée en ce que** la couche métallique (5) est appliquée sur la face supérieure (8) de la plaque de base (1), en permanence en surface, au moins dans la zone du composant et est, ainsi, exempte d'interruption dans la zone de composant.

16. Plaque de base (1) selon la revendication 15, **caractérisée en ce que** la couche métallique (5) est appliquée constamment en surface, sensiblement sur l'ensemble de la face supérieure (8) de la plaque de base (1) et, ainsi, étant essentiellement exempte d'interruption sur l'ensemble de la face supérieure (8) de la plaque de base (1).

17. Plaque de base (1) selon la revendication 15 ou 16, **caractérisée en ce que** le matériau de brasage (6a',6b',6c',6d') de la liaison brasée, présente une face extérieure concave.

18. Plaque de base (1) selon l'une des revendications 15 à 17, **caractérisée en ce que** la face de base (4) du composant (2) est convexe.

19. Plaque de base (a) selon l'une des revendications 15 à 18, **caractérisée en ce que** au moins l'un des plusieurs composants (2) comprend une fixation (2') pour maintenir une partie d'appui (2"), sur laquelle chaque fois au moins un élément micro-optique (3) est fixé, sachant que la fixation (2') est reliée à la partie d'appui (2") et que la partie d'appui (2") est reliée à l'élément micro-optique (3) par des points de brasage (10).

20. Substrat pour utilisation dans le procédé selon l'une des revendications 1 à 14, présentant les caractéristiques suivantes.
• une plaque de base (1) transparente au rayonnement laser
• au moins une couche métallique (5), et
• une couche de matériau de brasage (6c),
la plaque de base (1) étant enduite, sur une face (8) avec au moins une couche métallique (5), la couche métallique (5) étant appliquée constamment en surface, sensiblement sur la totalité de la face (8) de la plaque de base (1) et, ainsi, étant sensiblement exempt d'interruption sur la totalité de la face (8) de la plaque de base (1), et la couche en matériau de brasage (6c) étant appliquée, au moins sur une zone partielle de la couche métallique (5) de la plaque de base (1), selon un motif formé d'une pluralité d'éléments de brasage (6c") voisins.

21. Substrat selon la revendication 20, **caractérisé en ce que** le couche de matériau de brasage (6c, 6d) est appliquée sur l'ensemble de la couche métallique (5).
